# EUROPÄISCHE PATENTSCHRIFT

(11) **EP 1 626 441 B1**
(45) Veröffentlichungstag und Bekanntmachung des Hinweises auf die Patenterteilung: **03.10.2007**
(21) Anmeldenummer: 05017121.4
(22) Anmeldetag: 05.08.2005
(51) Int. Cl.: H01L 27/082, H01L 21/8222, H03F 3/45

(54) **Kaskodenschaltung, entsprechende Verwendung und Herstellungsverfahren**
Cascode circuit, corresponding use and manufacturing method
Circuit cascode, utilisation et procédé de fabrication correspondant

(30) Priorität: 10.08.2004 DE 102004038699
(43) Veröffentlichungstag der Anmeldung: 15.02.2006
(73) Patentinhaber: ATMEL Germany GmbH, 74072 Heilbronn (DE)
(72) Erfinder: Bromberger, Christoph Dipl.-Phys., 74074 Heilbronn (DE)
(74) Vertreter: Müller, Wolf-Christian

(56) Entgegenhaltungen:
- US-A- 4 651 410
- US-A- 4 771 013
- US-A- 5 329 145
- US-A1- 2001 045 619
- PATENT ABSTRACTS OF JAPAN Bd. 014, Nr. 257 (E-0936), 4. Juni 1990 (1990-06-04) -& JP 02 078267 A (HITACHI LTD), 19. März 1990 (1990-03-19)

## Beschreibung

Die vorliegende Erfindung betrifft eine Kaskodenschaltung, deren Verwendung und ein Verfahren zur vertikalen Integration von zwei Bipolartransistoren zu einer Kaskodenanordnung einer integrierten Kaskodenschaltung.

Eine in vielen Bereichen der Schaltungstechnik genutzte Standardschaltung ist eine Kaskodenschaltung, eine Reihenschaltung eines Transistors in Emitterschaltung und eines Transistors in Basisschaltung. Als Transistoren können sowohl Bipolartransistoren als auch Feldeffekttransistoren verwendet werden. US 4,651,410 offenbart eine derartige Kaskodenschaltung. Zudem ist aus JP 2078267 A eine Bipolartransistoranordnung auf einer leitfähigen Schicht bekannt.

Der Erfindung liegt die Aufgabe zu Grunde eine Kaskode anzugeben, die für Hochfrequenzschaltungen möglichst geeignet ist.

Diese Aufgabe wird erfindungsgemäß durch eine Kaskodenschaltung mit den Merkmalen des Patentanspruches 1, durch eine Verwendung einer Kaskodenschaltung mit den Merkmalen des Patentanspruchs 15, sowie durch ein Verfahren mit den Merkmalen des Patentanspruchs 16 gelöst. Günstige Ausgestaltungsformen sind Gegenstand von Unteransprüchen.

Das Wesen der Erfindung besteht darin einen ersten Transistor und einen zweiten Transistor einer Kaskodenschaltung in ein Bauelement zu integrieren, wobei das Halbleitergebiet des Emitters des ersten Transistors und das Halbleitergebiet des Kollektors des zweiten Transistors bezüglich einer Waferoberfläche oben liegen. Demzufolge ist eine Kaskode vorgesehen, die einen ersten Transistor mit einem ersten Basishalbleitergebiet, einem ersten Kollektorhalbleitergebiet und einem ersten Emitterhalbleitergebiet und einen zweiten Transistor mit einem zweiten Basishalbleitergebiet, einem zweiten Kollektorhalbleitergebiet und einem zweiten Emitterhalbleitergebiet aufweist. Dabei sind das erste Emitterhalbleitergebiet des ersten Transistors und das zweite Kollektorhalbleitergebiet des zweiten Transistors bezüglich einer Waferoberfläche geometrisch oben liegend angeordnet, während das erste Kollektorhalbleitergebiet des ersten Transistors und das zweite Emitterhalbleitergebiet des zweiten Transistors bezüglich der Waferoberfläche geometrisch unten liegend angeordnet sind. Ein weiterer Aspekt der Erfindung ist, dass das erste Kollektorhalbleitergebiet des ersten Transistors und das zweite Emitterhalbleitergebiet des zweiten Transistors an eine leitfähige, vergrabene Schicht angrenzen, die das erste Kollektorhalbleitergebiet des ersten Transistors und das zweite Emitterhalbleitergebiet des zweiten Transistors miteinander elektrisch verbindet.

Vorzugsweise sind die Halbleiterschichten der beiden Transistoren auf die vergrabene Schicht epitaktisch aufgewachsen, so dass die vergrabene, leitfähige Schicht nicht an die Oberfläche des Wafers angrenzt. Es kann jedoch vorteilhafterweise vorgesehen sein, dass die vergrabene, leitfähige Schicht zusätzlich mittels eines metallischen Kontaktes kontaktiert ist.

Eine Ausgestaltung der Erfindung sieht vor, dass der erste Transistor und der zweite Transistor durch eine Strukturierung des Wafers voneinander getrennt sind. Die Strukturierung kann beispielsweise durch eine geätzte Grabenstruktur gebildet sein. Bevorzugt ist zumindest eines der Halbleitergebiete des ersten Transistors von zumindest einem der Halbleitergebiete des zweiten Transistors durch einen Isolator voneinander isoliert. Als Isolator dient vorzugsweise Siliziumdioxid (SiO₂).

In einer anderen vorteilhaften Ausgestaltung der Erfindung grenzt der Isolator ebenfalls an die leitfähige, vergrabene Schicht, so dass keines der Halbleitergebiete des ersten Transistors an ein Halbleitergebiet des zweiten Transistors grenzt.

Gemäß einer bevorzugten Weiterbildung der Erfindung sind der erste Transistor und der zweite Transistor derart integriert, dass die pn-Übergänge der beiden Transistoren im wesentlichen parallel zur einer Waferoberfläche ausgebildet sind. Die Begrenzung der Randbereiche der pn-Übergänge ist vorteilhafterweise durch einen Isolator, beispielsweise ein Oxid gebildet, so dass die Begrenzung der Randbereiche in einem Winkel zur der Waferoberfläche ausgebildet ist. Vorteilhafterweise ist die Begrenzung im wesentlichen senkrecht zu der Waferoberfläche ausgebildet.

Die Erfindung weiterbildend ist zumindest einer der pn-Übergänge ein Heteroübergang. Bevorzugt ist dabei ein Basis-Emitterübergang der Heteroübergang. Hierbei ist beispielsweise das erste Basishalbleitergebiet des ersten Transistors aus einem ersten Halbleitermaterial und das erste Emitterhalbleitergebiet des ersten Transistors aus einem zweiten Halbleitermaterial gebildet. Dabei werden das erste Halbleitermaterial und das zweite Halbleitermaterial derart hergestellt, dass der Wert der Energielücke in dem ersten Halbleitermaterial um mindestens die mittlere thermische Energie der Ladungsträger kleiner ist, als der Wert der Energielücke in dem zweiten Halbleitermaterial. Beispielsweise besteht das erste Halbleitermaterial aus Si₁₋ₓGeₓ und das zweite Halbleitermaterial aus Si.

Eine bevorzugte Ausgestaltung der Erfindung sieht vor, dass das erste Kollektorhalbleitergebiet des ersten Transistors eine Dicke von weniger als 100nm aufweist. Der für Hochfrequenzanwendungen günstigste Wert der Dicke beträgt dabei 70 nm. Zudem ist in einer weiteren Ausgestaltung vorgesehen, dass das erste Kollektorhalbleitergebiet des ersten Transistors eine Dotierstoffkonzentration von mindestens 1 · 10¹⁷ cm⁻³ aufweist. Vorzugsweise liegt die Dotierstoffkonzentration im Bereich von 7 · 10¹⁷ cm⁻³.

Durch eine zusätzliche selektive Implantation von Dotanden in das zweite Emitterhalbleitergebiet des zweiten Transistors, weist in einer bevorzugten Ausgestaltung der Erfindung dieses Halbleitergebiet eine Dotierstoffkonzentration von mindestens 1 · 10¹⁸ cm⁻³, vorzugsweise von 2 · 10¹⁸ cm⁻³ auf.

Die Erfindung weiterbildend sind das erste Kollektorhalbleitergebiet des ersten Transistors und das zweite Emitterhalbleitergebiet des zweiten Transistors zumindest teilweise mit denselben Verfahrensschritten hergestellt. Beispielsweise sind die beiden Halbleitergebiete mittels derselben Epitaxie zeitgleich aufgebracht. Vorteilhafterweise weisen das erste Kollektorhalbleitergebiet des ersten Transistors und das zweite Emitterhalbleitergebiet des zweiten Transistors daher eine im wesentlichen gleiche Dicke auf.

Aufgrund einer Verwendung des ersten Transistors in Emitterschaltung und des zweiten Transistors in Basisschaltung, weist vorteilhafterweise der erste Transistor gegenüber dem zweiten Transistor eine geringere Durchbruchsspannungsfestigkeit auf. Der erste Transistor kann daher hinsichtlich seiner Transitfrequenz optimiert werden. Eine weitere Verbesserung der Hochfrequenzeigenschaften der Kaskode wird dadurch erzielt, dass die vergrabene, leitfähige Schicht einen möglichst kleinen Widerstand aufweist. Dabei ist es zwar prinzipiell möglich, metallische Leiter zu verwenden, vorzugsweise wird jedoch ein Material verwendet, auf das die beiden Bipolartransistoren expitaktisch aufgebracht werden können. Demzufolge ist in einer vorteilhaften Ausgestaltung der Erfindung vorgesehen, dass die leitfähige, vergrabene Schicht aus hochdotierten Silizium besteht. Der Leitungstyp der vergrabenen Schicht entspricht dabei dem Leitungstyp des ersten Kollektorhalbleitergebietes des ersten Transistors und des zweiten Emitterhalbleitergebietes des zweiten Transistors.

Die Erfindung weiterbildend besteht die vergrabene, leitfähige Schicht aus hochdotiertem Silizium, dem zumindest teilweise zwischen dem ersten Kollektorgebiet des ersten Transistor und dem zweiten Emittergebiet des zweiten Transistors eine ohmsche, mit der vergrabenen leitfähigen Schicht aus hochdotiertem Silizium verbundene Silizidschicht aufliegt. Alternativ kann die Silizidschicht auch zumindest teilweise zwischen dem ersten Emitterhalbleitergebiet des ersten Transistors und dem zweiten Kollektorhalbleitergebiet des zweiten Transistors auf dem hochdotiertem Silizium aufliegen.

Ein erster Aspekt der Erfindung ist eine Kaskodenschaltung mit einem ersten Transistor, der in Emitterschaltung beschaltet ist, und einem zweiten Transistor, der in Basisschaltung beschaltet ist. Ein Kollektorhalbleitergebiet des ersten Transistors und ein Emitterhalbleitergebiet des zweiten Transistors grenzen an eine leitfähige, vergrabene Schicht an, die das Kollektorhalbleitergebiet des ersten Transistors und das Emitterhalbleitergebiet des zweiten Transistors miteinander elektrisch verbindet. Der Eingang der Kaskodenschaltung ist dabei mit der Basis des ersten Transistors verbunden, während der Ausgang des Kaskodenschaltung mit dem Kollektor des zweiten Transistors verbunden ist. Beispielsweise mittels entsprechender Widerstände werden die Transistoren der Kaskodenschaltung in ihren Arbeitspunkten betrieben.

Ein zweiter Aspekt der Erfindung ist eine Verwendung einer zuvor beschriebenen Kaskodenschaltung mit einer zuvor beschriebenen Kaskode als Verstärkerbestandteil einer Hochfrequenzschaltung. Derartige Hochfrequenzschaltungen können beispielsweise in der Funkkommunikation verwendet werden.

Ein dritter Aspekt der Erfindung ist ein Verfahren zur vorzugsweise vertikalen Integration von zwei Bipolartransistoren zu einer Kaskodenanordnung einer integrierten Kaskodenschaltung, indem an eine leitfähige vergrabene Schicht angrenzend zeitgleich ein Kollektorhalbleitergebiet eines ersten Transistors der zwei Bipolartransistoren und ein Emitterhalbleitergebiet eines zweiten Transistors der beiden Bipolartransistoren aufgebracht wird. Vorzugsweise werden beide Halbleitergebiete in ein und demselben Epitaxieschritt auf ein darunter liegendes, angepasstes Gitter der vergrabenen Schicht aufgewachsen. Vorteilhafterweise wird in einem späteren Verfahrensschritt in das Emitterhalbleitergebiet des zweiten Transistors unter Maskierung des Kollektorhalbleitergebietes des ersten Transistors ein Dotierstoff selektiv implantiert.

Im Folgenden wird die Erfindung anhand von zeichnerisch dargestellten Ausführungsbeispielen näher erläutert.

Dabei zeigen
- Fig. 1: schematische Darstellung einer Anordnung von Halbleitergebieten einer Kaskodenstruktur;
- Fig. 2: ein zur Fig. 1 zugehöriger Schaltungsausschnitt mit npn-Bipolartransistoren; und
- Fig. 3: ein zur Fig. 1 zugehöriger Schaltungsausschnitt mit pnp-Bipolartransistoren.

Jede Halbleitertechnologie wird auf einen bestimmten Betriebsspannungsbereich hin optimiert. Die Durchbruchspannung eines Transistors wird vorrangig durch seine Kollektordicke und der Dotierstoffkonzentration im Halbleitergebiet des Kollektors bestimmt. Mit einer gegebenen Dicke des Kollektors lässt sich hierbei, unabhängig von der Dotierstoffkonzentration, eine bestimmte Durchbruchspannung nicht über- und eine bestimmte Grenzfrequenz nicht unterschreiten. Die innerhalb einer Hochfrequenztechnologie zur Verfügung stehenden Transistoren liegen innerhalb eines engen Bereiches von Kollektor-Emitter-Durchbruchspannungen oberhalb der gewünschten Betriebsspannung.

Die Spannungsfestigkeit einer Kaskode, und damit der mit der Kaskode erzielbare Spannungshub ΔU_{C}, wird durch die Basis-Kollektor-Durchbruchspannung des Transistors in Basisschaltung bestimmt. Die mit einer Kaskodenschaltung erzielbare Durchbruchspannung, bzw. der erzielbare Spannunghub ΔU_{C} liegt wesentlich über der Anforderung an die Spannungsfestigkeit der Standard-Bauelemente der Basistechnologie.

Wichtig bei Verwendung aktiver Bipolarbauelemente als Verstärkerelemente oder Schalter sind das transiente Verhalten und die Sperrfähigkeit. Eine Kenngröße zur Charakterisierung des transienten Verhaltens ist die Transitfrequenz f_{T}. Der am Kollektor erzielbare Spannungshub ΔU_{C} stellt eine Kenngröße für die Sperrfähigkeit dar, die umgekehrt proportional zur Höhe der Kollektordotierung ist.

Im Hochfrequenzbereich wird das transiente Verhalten von der Basis-Laufzeit und der Basis-Ladezeit bestimmt. Bei einer Signalübertragung wird die Basis-Emitter-Kapazität umgeladen. Die Umladung erfolgt um so schneller, je höher die Stromdichte ist. Hierdurch wächst die Transitfrequenz f_{T} zunächst mit steigendem Kollektorstrom an. Wird die Dichte der beweglichen Ladungsträger in der Kollektor-Driftzone vergleichbar mit der Ladungsdichte der Ionenrümpfe, erhöht sich die wirksame Basisweite (Kirk-Effekt). Hierdurch wird die Basis-Laufzeit vergrößert und die Transitfrequenz f_{T} sinkt bei hohen Stromdichten wieder ab.

Ferner ist die Stromdichte bei einsetzendem Kirk-Effekt proportional und die Basis-Ladezeit umgekehrt proportional zur Höhe der Kollektordotierung. Auch unter Vernachlässigung von Basis-Lauf- und Ladezeit ergibt sich aufgrund der Laufzeit durch die Basis-Kollektor-Raumladungszone eine materialabhängige Obergrenze des Johnson-Produkts, d. h., dem Produkt aus Transitfrequenz f_{T} und Spannungshub ΔU_{C}. Damit sinkt mit erhöhter Spannungsfestigkeit eines Transistors die erzielbare Betriebsfrequenz.

Aufgrund des niedrigen Eingangswiderstandes des Transistors in Basisschaltung erfährt der angesteuerte Transistor in Emitterschaltung nur einen geringen Spannungshub ΔU_{C}, so dass die Kaskodenschaltung bei der selben Stromverstärkung β wie der des angesteuerten Transistors eine höhere Early-Spannung Vₐ aufweist und der angesteuerte Transistor niedersperrend und schnell ausgeführt werden kann. In diesem Fall ist es für den Transistor in Emitterschaltung nicht notwendig, dass dieser eine Spannungsfestigkeit über der für die Zielanwendung Geforderten aufweist.

Zur Stromverstärkung wird ein Transistor meist in Emitterschaltung betrieben. Demgegenüber ist die Sperrfähigkeit in Basisschaltung typischerweise dreimal bis zehnmal so hoch. Durch Kaskodieren eines Transistors als Transistor in Basisschaltung mit einem niedersperrenden angesteuerten Transistor in Emitterschaltung werden hiernach der erzielbare Spannungshub ΔU_{C} und das Johnson-Produkt erhöht. Weiterhin wird durch den Übergang zu der Kaskodenschaltung der Miller-Effekt reduziert und die Transitfrequenz f_{T} erhöht.

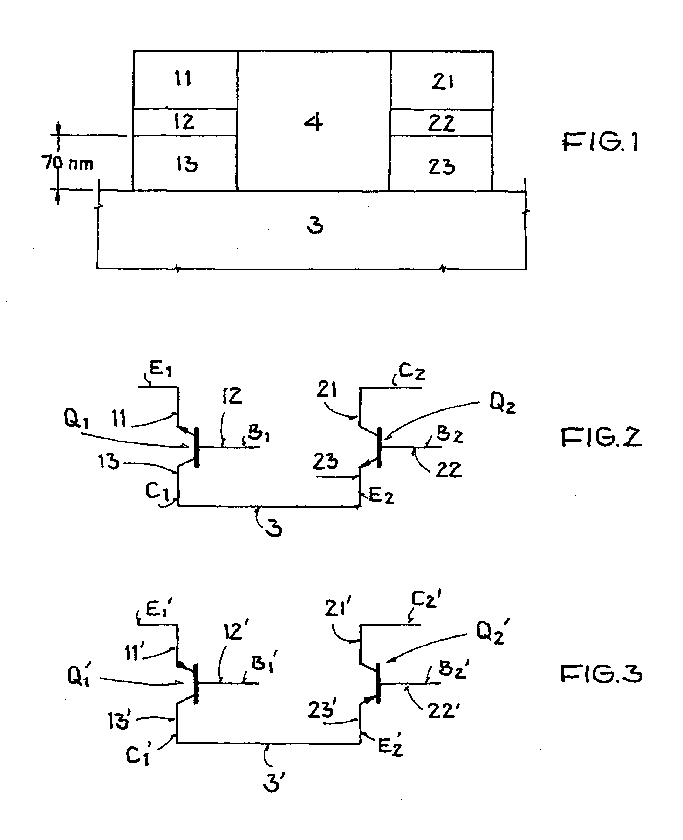

In der schematischen Darstellung der Anordnung von Halbleitergebieten der Fig. 1 sind zur vereinfachten Darstellung die metallischen Anschlusskontakte und das Siliziumsubstrat fortgelassen. Vielmehr beschränkt sich die Darstellung der Fig. 1 auf die funktional zusammenwirkenden Gebiete. Ausgehend von der Wafer-Oberfläche ist zu unterst eine leitende, vergrabene Schicht 3 angeordnet. Auf dieser leitenden, vergrabenen Schicht 3 sind ein erster Bipolartransistor mit den Halbleiterschichten 11, 12 und 13 und ein zweiter Bipolartransistor mit den Halbleiterschichten 21, 22 und 23 angeordnet, die durch einen Isolator 4 voneinander getrennt sind.

Eine erste Ausgestaltungsvariante sieht die Verwendung von npn-Transistoren vor. Ein zugehöriger Ausschnitt einer Schaltung ist in der Fig. 2 dargestellt. Demzufolge besteht der erste Transistor Q1 aus einem ersten Basishalbleitergebiet 12 einem ersten Emitterhalbleitergebiet 11 und einem ersten Kollektorhalbleitergebiet 13, wobei das erste Kollektorhalbleitergebiet 13 an die vergrabene, leitfähige Schicht 3 grenzt. Der zweite Transistor Q2 besteht aus einem zweiten Basishalbleitergebiet 22, einem zweiten Kollektorhalbleitergebiet 21 und einem zweiten Emitterhalbleitergebiet 23, wobei das zweite Emitterhalbleitergebiet 23 an die leitfähige, vergrabene Schicht 3 grenzt. Der Isolator 4 besteht aus Siliziumdioxid, während die vergrabene, leitfähige Schicht hochdotiertes Silizium aufweist.

Die Halbleiterschichten 12 und 22 bestehen dabei aus p-dotiertem Silizium, während die Halbleiterschichten 11, 13, 21, 23 und 3 n-dotiertes Silizium aufweisen. Neben den in Fig. 2 dargestellten Basisanschlüssen B1 und B2 und dem Emitteranschluss E1, des ersten Transistors Q1 und dem Kollektoranschluss C2, des zweiten Transistors Q2 kann auch die vergrabene Schicht 3 mittels eines metallischen Kontakte angeschlossen sein.

Der Kollektor des ersten Transistors Q1 mit geometrisch oben liegendem Emitter lässt sich in dieser Anordnung der Fig. 1 vorteilhaft ohne zusätzliche Kontakte und Metallbahnen direkt über die vergrabene leitfähige Schicht 3 elektrisch mit dem Emitter des zweiten Transistors Q2 mit geometrisch unten liegendem Emitter verbinden.

Da die in der Fig. 1 verwendeten Transistoren Q1 und Q2 nur innerhalb der als ein elektronisches Bauelement integrierten Kaskodenschaltung verwendet werden, sind sie in ihren Spannungsfestigkeiten nicht dadurch beschränkt, dass sie auch als Einzeltransistoren in Emitterschaltung im gewünschten Spannungsbereich Verwendung finden müssten. Durch die Anordnung der Fig. 1 werden die mit Hilfe der integrierten Kaskodenanordnung erzielbaren Transitfrequenzen f_{T} im Vergleich zu einer aus Einzelbauelementen lateral integrierten Kaskodenschaltung wesentlich erhöht. Weiterhin wird durch die Anordnung der Fig. 1 gegenüber einem lateralen Aufbau weniger Chipfläche benötigt. Zudem werden parasitäre Kapazitäten und Induktivitäten durch eingesparte Leitungsstrecken reduziert.

In Fig. 3 ist die komplementäre Anordnung mit pnp-Bipolartransistoren Q1' und Q2' dargestellt. Demzufolge sind die Halbleiterschichten 11', 13', 3', 21' und 23' p-dotiert. Die Basishalbleitergebiete 12' und 22' sind hingegen n-dotiert.

Um eine Kaskodenanordnung der Fig. 1 herzustellen ist ein Verfahren zur vertikalen Integration von zwei Bipolartransistoren Q1 und Q2 zu einer Kaskodenanordnung vorgesehen, indem an eine leitfähige, vergrabene Schicht 3 angrenzend zeitgleich ein Kollektorhalbleitergebiet 13 eines ersten Transistors Q1 der zwei Bipolartransistoren Q1 und Q2 und ein Emitterhalbleitergebiet 23 eines zweiten Transistors Q2 der beiden Bipolartransistoren Q1 und Q2 aufgebracht wird. Vorzugsweise wird in diesem Herstellungsverfahren in das Emitterhalbleitergebiet 23 des zweiten Transistors Q2 unter Maskierung des Kollektorhalbleitergebietes 13 des ersten Transistors Q1 ein Dotierstoff selektiv implantiert.

Weiterhin ist es vorteilhaft zumindest eines der Halbleitergebiete 11, 12, 13, 23, 22 oder 21 epitaktisch aufzubringen. Vorzugsweise ist dabei vorgesehen, die Halbleiterschichten 13 und 23 in einem einzigen Epitaxieschritt gemeinsam aufzubringen, so dass das erste Kollektorhalbleiterbiet 13 und das zweite Emitterhalbleitergebiet 23 eine Dicke von 70 nm aufweisen. Die Angabe der Dicke des ersten Kollektorhalbleitergebietes 13 in Fig. 1 gibt dabei keine Dicken oder Breiten für die anderen Halbleiterschichten (11, 12, 21, 22, 3) oder für den Isolator 4 an.

### Bezugszeichenliste

- 12, 22,: Halbleiterschicht eines ersten Leitungstyps
- 11', 13', 3', 21', 23':
- 11, 13, 3, 21, 23,: Halbleiterschicht eines zweiten Leitungstyps
- 12', 22':
- 4: Isolator
- E1, E2, E1', E2': Emitter
- B1, B2, B1', B2': Basis
- C1, C2, C1', C2': Kollektor
- Q1, Q2: npn-Bipolartransistor
- Q1', Q2': pnp-Bipolartransistor

## Patentansprüche

1. Kaskodenschaltung
- mit einem ersten Transistor (Q1) einer Kaskode, der in Emitterschaltung beschaltet ist, und
- einem zweiten Transistor (Q2) der Kaskode, der in Basisschaltung beschaltet ist,
bei der
der erste Transistor (Q1)
- ein erstes Basishalbleitergebiet (12),
- ein erstes Kollektorhalbleitergebiet (13) und
- ein erstes Emitterhalbleitergebiet (11) aufweist,
und bei der der zweite Transistor (Q2)
- ein zweites Basishalbleitergebiet (22),
- ein zweites Kollektorhalbleitergebiet (21) und
- ein zweites Emitterhalbleitergebiet (23) aufweist,
**dadurch gekennzeichnet, daß** das erste Kollektorhalbleitergebiet (13) (des ersten Transistors (Q1)) und das zweite Emitterhalbleitergebiet (23) (des zweiten Transistors (Q2)) an eine leitfähige, vergrabene Schicht (3) angrenzen, die das erste Kollektorhalbleitergebiet (13) (des ersten Transistors (Q1)) und das zweite Emitterhalbleitergebiet (23) (des zweiten Transistors (Q2)) miteinander elektrisch verbindet und
wobei das erste Emitterhalbleitergebiet (11) (des ersten Transistors (Q1)) und das zweite Kollektorhalbleitergebiet (21) (des zweiten Transistors (Q2)) bezüglich einer Waferoberfläche geometrisch oben liegen und das erste Kollektorhalbleitergebiet (13) (des ersten Transistors (Q1)) und das zweite Emitterhalbleitergebiet (23) (des zweiten Transistors, (Q2)) bezüglich der Waferoberfläche geometrisch unten liegen.

2. Kaskodenschaltung nach Anspruch 1, **dadurch gekennzeichnet, dass** der erste Transistor (Q1) und der zweite Transistor (Q2) durch eine Strukturierung des Wafers voneinander getrennt sind.

3. Kaskodenschaltung nach einem der Ansprüche 1 oder 2, **dadurch gekennzeichnet, dass** zumindest eines der Halbleitergebiete (11,12, 13) des ersten Transistors (Q1) von zumindest einem der Halbleitergebiete (21, 22, 23) des zweiten Transistors (Q2) durch einen Isolator (4), vorzugsweise durch Siliziumdioxid (SiO₂) voneinander isoliert ist.

4. Kaskodenschaltung nach Anspruch 3, **dadurch gekennzeichnet, dass** der Isolator (4) an die leitfähige, vergrabene Schicht (3) grenzt.

5. Kaskodenschaltung nach einem der vorhergehenden Ansprüche, **dadurch gekennzeichnet, dass** der erste Transistor (Q1) und der zweite Transistor (Q2) derart vertikal integriert sind, dass die pn-Übergänge der beiden Transistoren (Q1, Q2) im Wesentlichen parallel zu einer Waferoberfläche ausgebildet sind.

6. Kaskodenschaltung nach einem der vorhergehenden Ansprüche, **dadurch gekennzeichnet, dass** zumindest einer der pn-Übergänge ein Heteroübergang ist.

7. Kaskodenschaltung nach einem der vorhergehenden Ansprüche, **dadurch gekennzeichnet, dass** zumindest eines der Halbleitergebiete (11, 12, 13, 21, 22, 23, 3) epitaktisch aufgebracht ist.

8. Kaskodenschaltung nach einem der vorhergehenden Ansprüche, **dadurch gekennzeichnet, dass** das erste Kollektorhalbleitergebiet (13) des ersten Transistors (Q1) eine Dicke von weniger als 100nm, vorzugsweise 70nm aufweist.

9. Kaskodenschaltung nach einem der vorhergehenden Ansprüche, **dadurch gekennzeichnet, dass** das erste Kollektorhalbleitergebiet (13) des ersten Transistors (Q1) eine Dotierstoffkonzentration von mindestens 1 · 10¹⁷cm⁻³, vorzugsweise von 7 · 10¹⁷ cm⁻³ aufweist.

10. Kaskodenschaltung nach einem der vorhergehenden Ansprüche, **dadurch gekennzeichnet, dass** das zweite Emitterhalbleitergebiet (23) des zweiten Transistors (Q2) eine Dotierstoffkonzentration von mindestens 1 · 10¹⁸ cm⁻³, vorzugsweise von 2 · 10¹⁸ cm⁻³ aufweist.

11. Kaskodenschaltung nach einem der vorhergehenden Ansprüche, **dadurch gekennzeichnet, dass** das erste Kollektorhalbleitergebiet (13) des ersten Transistors (Q1) und das zweite Emitterhalbleitergebiet (23) des zweiten Transistors (Q2) eine im Wesentlichen gleiche Dicke aufweisen.

12. Kaskodenschaltung nach einem der vorhergehenden Ansprüche, **dadurch gekennzeichnet, dass** der erste Transistor (Q1) gegenüber dem zweiten Transistor (Q2) eine geringere Durchbruchsspannungsfestigkeit aufweist.

13. Kaskodenschaltung nach einem der vorhergehenden Ansprüche, **dadurch gekennzeichnet, dass** die leitfähige, vergrabene Schicht (3) hochdotiertes Silizium aufweist.

14. Kaskodenschaltung nach Anspruch 13, **dadurch gekennzeichnet, dass** die vergrabene Schicht (3) hochdotiertes Silizium aufweist, dem zumindest teilweise zwischen dem ersten Kollektorhalbleitergebjet (13) des ersten Transistors (Q1) und dem zweiten Emitterhalbleitergebiet (23) des zweiten Transistors (Q2) oder zwischen dem ersten Emitterhalbleitergebiet (11) des ersten Transistors (Q1) und dem zweiten Kollektorhalbleitergebiet (21) des zweiten Transistors (Q2) eine ohmsche, mit dem hochdotierten Silizium verbundene Silizidschicht aufliegt.

15. Verwendung einer Kaskodenschaltung nach einem der vorhergehenden Ansprüche als Verstärkerbestandteil einer Hochfrequenzschaltung.

16. Verfahren zur vertikalen Integration eines ersten Transistors (Q1) in Emitterschaltung und eines zweiten Transistors (Q2) in Basisschaltung zu einer Kaskodenanordnung einer integrierten Kaskodenschaltung, **dadurch gekennzeichnet, dass** zur leitfähigen Verbindung mit einer vergrabenen Schicht (3) an diese leitfähige vergrabene Schicht (3) angrenzend zeitgleich ein Kollektorhalbleitergebiet (13) des ersten Transistors (Q1) und ein Emitterhalbleitergebiet (23) des zweiten Transistors (Q2) derart aufgebracht wird, dass die vergrabene Schicht (3) das Kollektorhalbleitergebiet (13) des ersten Transistors (Q1) und das Emitterhalbleitergebiet (23) des zweiten Transistors (Q2) leitfähig verbindet.

17. Verfahren zur vertikalen Integration nach Anspruch 16, **dadurch gekennzeichnet, dass** in das Emitterhalbleitergebiet (23) des zweiten Transistors (Q2) unter Maskierung des Kollektorhalbleitergebietes (13) des ersten Transistors (Q1) ein Dotierstoff selektiv implantiert wird.

18. Verfahren zur vertikalen Integration nach einem der Ansprüche 16 oder 17, **dadurch gekennzeichnet, dass** das erste Kollektorhalbleitergebiet (13) des ersten Transistors (Q1) mittels derselben Epitaxie hergestellt wird wie das zweite Emitterhalbleitergebiet (23) des zweiten Transistors (Q2).

## Claims

1. Cascade circuit
- with a first transistor (Q1) of a cascade, which is connected in the emitter circuit, and
- a second transistor (Q2) of the cascade, which is connected in the base circuit,
in which the first transistor (Q1) comprises
- a first base semiconductor region (12),
- a first collector semiconductor region (13) and
- a first emitter semiconductor region (11),
and in which the second transistor (Q2) comprises
- a second base semiconductor region (22),
- a second collector semiconductor region (21) and
- a second emitter semiconductor region (23),
**characterised in that** the first collector semiconductor region (13) (of the first transistor (Q1)) and the second emitter semiconductor region (23) (of the second transistor (Q2)) adjoin a conductive buried layer (3) which electrically interconnects the first collector semiconductor region (13) (of the first transistor (Q1)) and the second emitter semiconductor region (23) (of the second transistor (Q2)) and wherein the first emitter semiconductor region (11) (of the first transistor (Q1)) and the second collector semiconductor region (21) (of the second transistor (Q2)) lie geometrically at the top with respect to a wafer surface and the first collector semiconductor region (13) (of the first transistor (Q1)) and the second emitter semiconductor region (23) (of the second transistor (Q2)) lie geometrically at the bottom with respect to the wafer surface.

2. Cascade circuit according to claim 1, **characterised in that** the first transistor (Q1) and the second transistor (Q2) are separated from one another by a structuring of the wafer.

3. Cascade circuit according to one of claims 1 and 2, **characterised in that** at least one of the semiconductor regions (11, 12, 13) of the first transistor (Q1) is insulated from at least one of the semiconductor regions (21, 22, 23) of the second transistor (Q2) by an insulator (4), preferably by silicon dioxide (SiO₂).

4. Cascade circuit according to claim 3, **characterised in that** the insulator (4) adjoins the conductive buried layer (3).

5. Cascade circuit according to one of the preceding claims, **characterised in that** the first transistor (Q1) and the second transistor (Q2) are vertically integrated in such a manner that the pn transitions of the two transistors (Q1, Q2) are formed substantially parallel to a wafer surface.

6. Cascade circuit according to one of the preceding claims, **characterised in that** at least one of the pn transitions is a hetero-transition.

7. Cascade circuit according to one of the preceding claims, **characterised in that** at least one of the semiconductor regions (11, 12, 13, 21, 22, 23, 3) is formed epitaxially.

8. Cascade circuit according to one of the preceding claims, **characterised in that** the first collector semiconductor region (13) of the first transistor (Q1) has a thickness of less than 100 nm, preferably 70 nm.

9. Cascade circuit according to one of the preceding claims, **characterised in that** the first collector semiconductor region (13) of the first transistor (Q1) has a doping material concentration of at least 1 · 10¹⁷ cm⁻³, preferably of 7 · 10¹⁷ cm⁻³.

10. Cascade circuit according to one of the preceding claims, **characterised in that** the second emitter semiconductor region (23) of the second transistor (Q2) has a doping material concentration of at least 1 · 10¹⁸ cm⁻³, preferably of 2 · 10¹⁸ cm⁻³.

11. Cascade circuit according to one of the preceding claims, **characterised in that** the first collector semiconductor region (13) of the first transistor (Q1) and the second emitter semiconductor region (23) of the second transistor (Q2) have substantially the same thickness.

12. Cascade circuit according to one of the preceding claims, **characterised in that** the first transistor (Q1) has a lower breakthrough voltage strength by comparison with the second transistor (Q2).

13. Cascade circuit according to one of the preceding claims, **characterised in that** the conductive, buried layer (3) comprises high-doped silicon.

14. Cascade circuit according to claim 13, **characterised in that** the buried layer (3) comprises high-doped silicon on which a resistive silicide layer, which is connected with the high-doped silicon, rests at least partly between the first collector semiconductor region (13) of the first transistor (Q1) and the second emitter semiconductor region (23) of the second transistor (Q2) or between the first emitter semiconductor region (11) of the first transistor (Q1) and the second collector semiconductor region (21) of the second transistor (Q2).

15. Use of a cascade circuit according to one of the preceding claims as an amplifier component of a high-frequency circuit.

16. Method for vertical integration of a first transistor (Q1) in an emitter circuit and a second transistor (Q2) in a base circuit to form a cascade arrangement of an integrated cascade circuit, **characterised in that** for the conductive connection with a buried layer (3) a collector semiconductor region (13) of the first transistor (Q1) and an emitter semiconductor region (23) of the second transistor (Q2) are formed at the same time to adjoin this conductive buried layer (3) in such a manner that the buried layer (3) conductively connects the collector semiconductor region (13) of the first transistor (Q1) and the emitter semiconductor region (23) of the second transistor (Q2).

17. Method for vertical integration according to claim 16, **characterised in that** a doping material is selectively implanted in the emitter semiconductor region (23) of the transistor (Q2) with masking of the collector semiconductor region (13) of the first transistor (Q1).

18. Method for vertical integration according to one of claims 16 and 17, **characterised in that** the first collector semiconductor region (13) of the first transistor (Q1) is produced by means of the same epitaxy as the second emitter semiconductor region (23) of the second transistor (Q2).

## Revendications

1. Circuit en cascode, comprenant
- un premier transistor (Q1) d'une cascode, monté en circuit émetteur, et
- un deuxième transistor (Q2) de la cascode, monté en circuit de base,
dans lequel
le premier transistor (Q1) présente
- un premier domaine semi-conducteur de base (12)
- un premier domaine semi-conducteur de collecteur (13), et
- un premier domaine semi-conducteur d'émetteur (11),
et dans lequel
le deuxième transistor (Q2) présente
- un deuxième domaine semi-conducteur de base (22)
- un deuxième domaine semi-conducteur de collecteur (21)
- un deuxième domaine semi-conducteur d'émetteur (23),
**caractérisé en ce que** le premier domaine semi-conducteur de collecteur (13) (du premier transistor (Q1)) et le deuxième domaine semi-conducteur d'émetteur (23) (du deuxième transistor (Q2)) sont contigus à une couche conductrice enfouie (3) qui relie entre eux de manière électrique le premier domaine semi-conducteur de collecteur (13) (du premier transistor (Q1)) et le deuxième domaine semi-conducteur d'émetteur (23) (du deuxième transistor (Q2)), et
dans lequel le premier domaine semi-conducteur d'émetteur (11) (du premier transistor (Q1)) et le deuxième domaine semi-conducteur de collecteur (21) (du deuxième transistor (Q2)) sont situés géométriquement en haut par rapport à une surface d'une plaquette, et le premier domaine semi-conducteur de collecteur (13) (du premier transistor (Q1)) et le deuxième domaine semi-conducteur d'émetteur (23) (du deuxième transistor (Q2)) sont situés géométriquement en-dessous par rapport à la surface de la plaquette.

2. Circuit en cascode selon la revendication 1, **caractérisé en ce que** le premier transistor (Q1) et le deuxième transistor (Q2) sont séparés par une structuration de la plaquette.

3. Circuit en cascode selon l'une quelconque des revendications 1 ou 2, **caractérisé en ce qu'**au moins un des domaines semi-conducteurs (11,12,13) du premier transistor (Q1) est isolé d'au moins un des domaines semi-conducteurs (21,22,23) du deuxième transistor (Q2) par un isolant (4), de préférence par de l'oxyde de silicium (SiO₂).

4. Circuit en cascode selon la revendication 3, **caractérisé en ce que** l'isolant (4) est contigu à la couche (3) conductrice enfouie.

5. Circuit en cascode selon l'une quelconque des revendications précédentes, **caractérisé en ce que** le premier transistor (Q1) et le deuxième transistor (Q2) sont intégrés verticalement de telle manière que les transitions p-n des deux transistors (Q1, Q2) sont conformées sensiblement parallèles à une surface d'une plaquette.

6. Circuit en cascode selon l'une quelconque des revendications précédentes, **caractérisé en ce qu'**au moins une des transitions p-n est une hétérotransition.

7. Circuit en cascode selon l'une quelconque des revendications précédentes, **caractérisé en ce qu'**au moins un des domaines semi-conducteurs (11,12,13,21,22,23,3) est appliqué de manière épitaxique.

8. Circuit en cascode selon l'une quelconque des revendications précédentes, **caractérisé en ce que** le premier domaine semi-conducteur de collecteur (13) du premier transistor (Q1) présente une épaisseur inférieure à 100nm, de préférence 70nm.

9. Circuit en cascode selon l'une quelconque des revendications précédentes, **caractérisé en ce que** le premier domaine semi-conducteur de collecteur (13) du premier transistor (Q1) présente une concentration en dopant d'au moins 1 à 10¹⁷ par cm⁻³, de préférence de 7 à 10¹⁷ par cm⁻³.

10. Circuit en cascode selon l'une quelconque des revendications précédentes, **caractérisé en ce que** le deuxième domaine semi-conducteur d'émetteur (23) du deuxième transistor (Q2) présente une concentration en dopant d'au moins 1 à 10¹⁸ par cm⁻³, de préférence de 2 à 10¹⁸ par cm⁻³.

11. Circuit en cascode selon l'une quelconque des revendications précédentes, **caractérisé en ce que** le premier domaine semi-conducteur de collecteur (13) du premier transistor (Q1) et le deuxième domaine semi-conducteur d'émetteur (23) du deuxième transistor (Q2) présentent une épaisseur sensiblement identique.

12. Circuit en cascode selon l'une quelconque des revendications précédentes, **caractérisé en ce que** le premier transistor (Q1) présente par rapport au deuxième transistor (Q2) une faible résistance à la tension de claquage.

13. Circuit en cascode selon l'une quelconque des revendications précédentes, **caractérisé en ce que** la couche (3) conductrice enfouie présente du silicium fortement dopé.

14. Circuit en cascode selon la revendication 13, **caractérisé en ce que** la couche (3) enfouie présente du silicium fortement dopé sur lequel est déposée au moins partiellement une couche de silicides ohmique, reliée au silicium fortement dopé, entre le premier domaine semi-conducteur de collecteur (13) du premier transistor (Q1) et le deuxième domaine semi-conducteur d'émetteur (23) du deuxième transistor (Q2) ou entre le premier domaine semi-conducteur d'émetteur (11) du premier transistor (Q1) et le deuxième domaine semi-conducteur de collecteur (21) du deuxième transistor (Q2).

15. Utilisation d'un circuit en cascode selon l'une quelconque des revendications précédentes comme composant d'amplification d'un circuit à haute fréquence.

16. Procédé d'intégration verticale d'un premier transistor (Q1) en circuit émetteur et d'un deuxième transistor (Q2) en circuit de base dans un montage en cascode d'un circuit en cascode intégré, **caractérisé en ce que** pour établir la liaison conductrice avec une couche enfouie (3), on applique simultanément un domaine semi-conducteur de collecteur (13) du premier transistor (Q1) et un domaine semi-conducteur d'émetteur (23) du deuxième transistor (Q2) contigus à cette couche conductrice enfouie (3) de telle façon que la couche enfouie (3) établit une liaison conductrice entre le domaine semi-conducteur de collecteur (13) du premier transistor (Q1) et le domaine semi-conducteur d'émetteur (23) du deuxième transistor (Q2).

17. Procédé d'intégration verticale selon la revendication 16, **caractérisé en ce qu'**un dopant est implanté de manière sélective dans le domaine semi-conducteur d'émetteur (23) du deuxième transistor (Q2) en masquant le domaine semi-conducteur de collecteur (13) du premier transistor (Q1).

18. Procédé d'intégration verticale selon l'une quelconque des revendications 16 ou 17, **caractérisé en ce que** le premier domaine semi-conducteur de collecteur (13) du premier transistor (Q1) est réalisé au moyen de la même épitaxie que le deuxième domaine semi-conducteur d'émetteur (23) du deuxième transistor (Q2).
